# EUROPÄISCHE PATENTSCHRIFT

(11) **EP 2 379 783 B1**
(45) Veröffentlichungstag und Bekanntmachung des Hinweises auf die Patenterteilung: **28.05.2014**
(21) Anmeldenummer: 10706486.7
(22) Anmeldetag: 19.01.2010
(51) Int. Cl.: C30B 13/00, C30B 13/10, C30B 13/20, C30B 15/00, C30B 15/04

(54) **VERFAHREN UND VORRICHTUNG ZUR HERSTELLUNG VON SILIZIUMDÜNNSTÄBEN**
METHOD AND DEVICE FOR PRODUCING THIN SILICON RODS
PROCÉDÉ ET DISPOSITIF DE FABRICATION DE BARRES DE SILICIUM FINES

(30) Priorität: 21.01.2009 DE 102009005837
(43) Veröffentlichungstag der Anmeldung: 26.10.2011
(73) Patentinhaber: PV Crystalox Solar Silicon GmbH, 99099 Erfurt (DE)
(72) Erfinder: RIEMANN, Helge, 15732 Schulzendorf (DE); SCHULZE, Friedrich-Wilhelm, 99448 Kranichfeld (DE); FISCHER, Jörg, 12623 Berlin (DE); RENNER, Matthias, 15537 Wernsdorf (DE)
(74) Vertreter: Hoffmann, Heinz-Dietrich
(86) Internationale Anmeldenummer: PCT/DE2010/000070
(87) Internationale Veröffentlichungsnummer: WO 2010/083818

(56) Entgegenhaltungen:
- DE-A1- 2 952 602

## Beschreibung

Die Erfindung betrifft ein Verfahren und eine Vorrichtung zur Herstellung von Siliziumdünnstäben, wie sie beim herkömmlichen Siemens-Verfahren für die Siliziumabscheidung verwendet werden. Dabei werden die Dünnstäbe in einem Reaktor senkrecht angeordnet und durch Stromdurchgang auf ca.1100°C erhitzt, so dass sich auf ihnen aus einem Trichlorsilan-Wasserstoffgemisch das Silizium pyrolytisch abscheidet. Dieser grundsätzliche Herstellungsprozess für das polykristalline Silizium ist für die Elektronik- wie für die Solarindustrie fast identisch.

### Beschreibung des Standes der Technik

Durch den stark angestiegenen und weiter steigenden Bedarf an polykristallinem Silizium als Ausgangsmaterial von Silizium für Halbleiter und als Ausgangsmaterial von Solarzellen steigt auch entsprechend der Bedarf an Siliziumdünnstäben mit einem Durchmesser von ca. 4 - 10mm. Die Herstellung der Siliziumdünnstäbe ist ein unumgänglicher und teilweise auch begrenzender Bestandteil der Produktion von Siliziumstäben durch die pyrolytische Abscheidung von Silizium aus Trichlorsilan (Siemensverfahren) oder auch analog aus Monosilan. Da die Gesamtlänge der Siliziumdünnstäbe der Länge der produzierten Si- Stäbe entspricht, werden mit dem steilen Anstieg der Solar- und Halbleiter- Siliziumproduktion auch entsprechend große Mengen dieser Dünnstäbe gebraucht.

Siliziumdünnstäbe werden beispielsweise nach dem klassischen Pedestal-Verfahren hergestellt, indem der Stab aus dem Innenloch einer einwindigen Induktionsspule gezogen wird, die gleichzeitig das obere Ende eines Rohstabes von 30-50 mm Durchmesser aufschmilzt. Zur Herstellung von Siliziumstäben sind verschiedene Verfahren beschrieben worden.

Ein Beispiel ist in der DE 10 2005 016 776 A1 beschrieben, bei dem in einer Startphase aus einem hängenden Schmelztropfen mit bekannten Mitteln durch die zentrale Öffnung einer einwindigen Induktionsspule ein Dünnhals vertikal abwärts gezogen wird. Bei Erreichen eines für die Flächenmaße des zu ziehenden Kristalls notwendigen Durchmessers wird die Rotation des wachsenden Kristalls auf eine Drehzahl unter 1 U/min reduziert. Anschließend wird in einer Züchtungsphase ein Si-Einkristall mit annähernd rundem Querschnitt vertikal abwärts gezogen, wobei der verwendete Induktor Mittel zur Erzeugung eines nahezu rotationssymmetrischen Temperaturprofils an der Wachstumsphasengrenze aufweist.

In der DE 29 52 602 A1 wird ein Verfahren und eine Vorrichtung zum Herstellen von Silizium-Dünnstäben beschrieben. Dabei wird aus einem senkrecht stehenden Vorratsstab, der an seinem oberen Ende mittels einer Induktionsspule aufgeschmolzen wird, ein an seinem oberen Ende gehalterter Silizium-Dünnstab nach oben gezogen. Damit der wachsende Silizium-Dünnstab stabilisiert wird, sind entsprechende Stabilisierungsmittel vorgesehen, die aus Federstäben bestehen, zwischen denen der Silizium-Dünnstab geführt wird.

Ein weiteres Verfahren zur Herstellung von Dünnstäben ist der DE 24 58 490 A1 zu entnehmen. Hierbei werden kreisförmig gebogene Dünnstäbe für den Trägerkörper bei der Materialabscheidung durch Abziehen von der geschmolzenen Kuppe eines Dickstabes mittels einer ringförmigen Induktionsspule längs einer Kreisbahn mittels eines Motors mit hoch untersetztem Getriebe bei reiner Drehbewegung gezogen.

Bei den vorgenannten Verfahren kann jeweils nur ein Dünnstab aus der Schmelze eines Rohstabes gezogen werden.

Für die Abscheidung von polykristallinen Si-Stäben können auch Vierkant-Seelen verwendet werden, die aus großen Si-Stäben wie Leisten gesägt werden. Gesägte Vierkant-Seelen haben eine gestörte und verunreinigte Oberfläche. Dadurch sind sie sehr bruchempfindlich und sie müssen nasschemisch geätzt und gereinigt werden. Werden sie aus original abgeschiedenen hochreinen Poly- Si Stäben gesägt, haben sie außerdem einen ungünstig hohen elektrischen Widerstand, der im Abscheideprozess den Prozessstart verkompliziert. Ihre Länge ist auch immer etwas kleiner als die des verwendeten Stabes, aus dem sie gesägt werden.

Die **Aufgabe** der Erfindung besteht darin, ein Verfahren und eine Vorrichtung anzugeben, mit denen es möglich ist in einem Arbeitsgang aus einem Vorratsstab mit Standarddurchmesser von z.B. 120mm gleichzeitig mehrere Siliziumdünnstäbe mit der Materialreinheit zonengezogener Si-Kristalle und den gewünschten Parametern herzustellen. Mit dem Verfahren sollen die Produktionskosten für die Dünnstabproduktion durch wegfallende Herstellung von Sondermaterial sowie die Arbeits- und Energiekosten gesenkt werden.

Erfindungsgemäß wird diese Aufgabe durch ein Verfahren mit den Merkmalen des Patentanspruchs 1 gelöst, wobei das Verfahren dem klassischen Pedestal- Verfahren ähnelt, bei dem als Heizquelle eine nur eine Windung aufweisende flache Induktionsspule verwendet wird, die gleichzeitig das obere Ende eines Rohstabes aufschmilzt und gleichzeitig der Einstellung der Kristallisationsfront an den wachsenden Siliziumdünnstäben dient, die aus der Schmelze nach oben gezogen werden. Die verwendete scheibenförmige einwindige Induktionsspule weist einen Hauptschlitz, der als Stromzuführung ausgebildet ist, und in der Mitte eine Zentralöffnung auf. Im Gegensatz zum bekannten Stand der Technik wird durch die stromumflossene Zentralöffnung kein Siliziumdünnstab nach oben gezogen, sie bleibt frei. Erfindungsgemäß weist die Induktionsspule um die stromumflossene Zentralöffnung weitere Durchgangslöcher auf, die als Ziehöffnungen für die Siliziumdünnstäbe dienen. Unter der vom HF-Strom durchflossenen Induktionsspule wird ein ausreichend gleichmäßiges Temperaturprofil erzeugt, das die Entstehung eines Schmelzensees in der Kuppe des Vorratsstabes bewirkt. Durch die weiteren Ziehöffnungen in der Induktionsspule kann jeweils ein Siliziumdünnstab aus dem darunter befindlichen Schmelzensee nach oben gezogen werden. Der Durchmesser der einwindigen Induktionsspule ist größer als der Durchmesser des Si-Rohstabes, welcher vorteilhafterweise einen technisch üblichen relativ großen Durchmesser aufweist. Die weiteren zusätzlichen Ziehöffnungen sind vorzugsweise konzentrisch oder paarweise und jeweils symmetrisch zur Zentralöffnung angeordnet. Ihr Abstand ist so gewählt, dass die wachsenden Siliziumdünnstäbe sich gegenseitig thermisch nicht zu stark beeinflussen, damit die einzelnen Siliziumdünnstäbe möglichst gleich wachsen. Je größer der Durchmesser des verwendeten Si-Rohstabes ist, desto größer kann auch der Durchmesser der Induktionsspule gewählt werden und es können somit auch eine entsprechende Anzahl zusätzlicher Ziehöffnungen vorgesehen werden.

Vorteilhafterweise sind oberhalb der Induktionsspule Mittel vorgesehen, die eine aktive Wärmezufuhr vom Magnetfeld der Induktionsspule zu den kristallisierenden Siliziumdünnstäben verhindern, um ein gleichmäßiges Kristallwachstum zu unterstützen.

In der Startphase wird nach dem Aufschmelzen der Kuppe des, an seinem unteren Ende gehalterten, senkrecht stehenden Si-Rohstabes durch jede weitere Ziehöffnung in der Induktionsspule jeweils ein an einem Träger befestigtes Silizium-Keimstäbchen mit der Schmelze in Kontakt gebracht. Mit Beginn des Kristallwachstums werden die Träger mit einer derartigen Geschwindigkeit nach oben gezogen, dass an jedem Träger ein Siliziumdünnstab gleichmäßig wächst. Dabei wird der Si-Rohstab während des Ziehprozesses mit einer solchen Geschwindigkeit nach oben nachgeführt, dass in Abhängigkeit der Ziehgeschwindigkeit der Siliziumdünnstäbe nach oben und der Anzahl der Siliziumdünnstäbe jederzeit für alle wachsenden Dünnstäbe eine ausreichende Menge an Si-Schmelze gewährleistet wird.

Vorzugsweise werden alle Träger synchron, d. h. gleichzeitig und mit gleicher Geschwindigkeit, nach oben gezogen.

Es hat sich gezeigt, dass es von Vorteil ist, wenn die Siliziumdünnstäbe eine Dotierung aufweisen, die ein direktes und ausschließliches Aufheizen im Siemens-Reaktor erlauben. Damit dies ermöglicht wird, weist die Si-Schmelze durch besondere Maßnahmen eine solche Dotierung mit Bor und/oder anderen dotierenden Elementen auf, dass die gezogenen Siliziumdünnstäbe die gewünschte Dotierung aufweisen.

Das Verfahren wird vorzugsweise in einer Ziehkammer unter Schutzgasatmosphäre durchgeführt.

Die erfindungsgemäße Vorrichtung zur Durchführung des Verfahrens weist die Merkmale des Patentanspruchs 9 auf. Das wesentliche erfindungsgemäße Merkmal besteht darin, dass die als Heizquelle verwendete, nur eine Windung aufweisende, Induktionsspule neben der, aus dem Stand der Technik bekannten, Zentralöffnung, die sich an den Hauptschlitz anschließt, weitere Durchgangslöcher aufweist, die als Ziehöffnungen verwendet werden. Um diese Ziehöffnungen kreist kein separater Ringstrom, sie stellen somit weitgehend induktiv passive Durchgangslöcher in der Scheibe der Induktionsspule dar. Die Ziehöffnungen weisen einen derartigen Durchmesser auf, dass die herzustellenden Siliziumdünnstäbe durch sie hindurch gezogen werden können.

Diese zusätzlichen Ziehöffnungen sind vorzugsweise paarweise und symmetrisch oder aber konzentrisch zur Zentralöffnung und mit einem ausreichenden Abstand zum Rand der Induktionsspule angeordnet. Dabei weisen benachbarte Ziehöffnungen jeweils ähnliche Abstände auf, so dass die durch diese hindurch nach oben gezogenen Siliziumdünnstäbe praktisch gleiche Durchmesser aufweisen und sich gegenseitig thermisch nicht zu stark beeinflussen.

Der als Vorratsstab verwendete Si-Rohstab ist auf einer vertikal verschiebbaren Spindel angeordnet, die auch rotieren kann.

Über der Induktionsspule sind vertikal verschiebbare vorzugsweise nicht rotierende Träger angeordnet, die die Silizium-Keimstäbchen zum Züchten der Siliziumdünnstäbe tragen. Jeder Träger wird in der Startphase des Verfahrens durch jeweils eine Ziehöffnung so weit abgesenkt, dass das Silizium-Keimstäbchen mit der Schmelze am oberen Ende des Si-Rohstabes in Berührung kommt. Mit Beginn des Kristallwachstums wird der Träger mit einer solchen Geschwindigkeit nach oben gezogen, dass am Impfstab ein Siliziumdünnstab wächst, der mittels des jeweiligen Trägers durch die jeweilige passive Ziehöffnung gezogen wird. Vorzugsweise sind die Träger miteinander derart verbunden, dass sie synchron, gleichzeitig und mit gleicher Ziehgeschwindigkeit nach oben bewegt werden, so dass für jeden Siliziumdünnstab ein fast gleiches Kristallwachstum gewährleistet ist. Während die Siliziumdünnstäbe wachsen und nach oben abgezogen werden, wird der Si-Rohstab mit seiner Spindel mit einer solchen Geschwindigkeit nach oben nachgeführt, dass jederzeit eine ausreichende aufgeschmolzene Materialmenge zur Verfügung steht, damit die wachsenden Siliziumdünnstäbe mit optimaler Ziehgeschwindigkeit gezogen werden können.

In Abhängigkeit des Querschnittes des verwendeten Si-Rohstabes ist der Querschnitt der Induktionsspule zu wählen; der stets größer als der des Si-Rohstabes ist. Bei den derzeit üblichen Querschnitten der verwendeten Si-Rohstäbe weist die erfindungsgemäße Induktionsspule vier oder mehr zusätzliche Löcher zum Ziehen von Siliziumdünnstäben auf.

Damit ein gleichmäßiges Kristallwachstum der wachsenden Siliziumdünnstäbe gewährleistet wird, ist dicht oberhalb der Induktionsspule eine Abschirmplatte vorgesehen, die eine induktive Wärmezufuhr über das Magnetfeld der Induktionsspule zu den kristallisierenden Siliziumdünnstäben unterdrücken soll. Die Abschirmplatte weist kongruent zu den Ziehöffnungen in der Induktionsspule angeordnete Öffnungen in Form von Durchgangsbohrungen auf. Somit können die wachsenden Siliziumdünnstäbe durch die Induktionsspule und die Abschirmung hindurch nach oben gezogen werden.

Damit eine möglichst kleine Ziehkammer für die Vorrichtung verwendet werden kann und trotzdem möglichst lange Siliziumdünnstäbe kontinuierlich gezogen werden können, werden zur Durchführung der Träger und der Siliziumdünnstäbe durch die obere Wandung der Ziehkammer entsprechende Gasschleusen vorgesehen. Diese Gasschleusen bestehen üblicherweise aus langen Röhren, die einen geringfügig größeren Innenquerschnitt aufweisen als der Querschnitt der wachsenden Siliziumdünnstäbe.

Die Vorteile des erfindungsgemäßen Verfahrens und der zur Durchführung dieses Verfahrens vorgeschlagenen Vorrichtung bestehen darin, dass gleichzeitig in einem Ziehprozess mehrere Siliziumdünnstäbe tiegelfrei hergestellt werden können. Somit wächst die Produktivität entsprechend der Anzahl der gleichzeitig gezogenen Siliziumdünnstäbe. Außerdem wird die Energiebilanz bei der Herstellung der Siliziumdünnstäbe wesentlich verbessert, da mit vergleichbarem Energieeinsatz mehrere Siliziumdünnstäbe gleichzeitig hergestellt werden können.

Das erfindungsgemäße Verfahren und die zur Durchführung des Verfahrens vorgeschlagene Vorrichtung werden nachfolgend in einem Ausführungsbeispiel anhand von Zeichnungen näher erläutert.

Die Figuren zeigen:
- Fig. 1:: Draufsicht auf die Induktionsspule
- Fig. 2:: Seitenansicht der Vorrichtung
- Fig. 3:: Perspektivische Ansicht der Vorrichtung

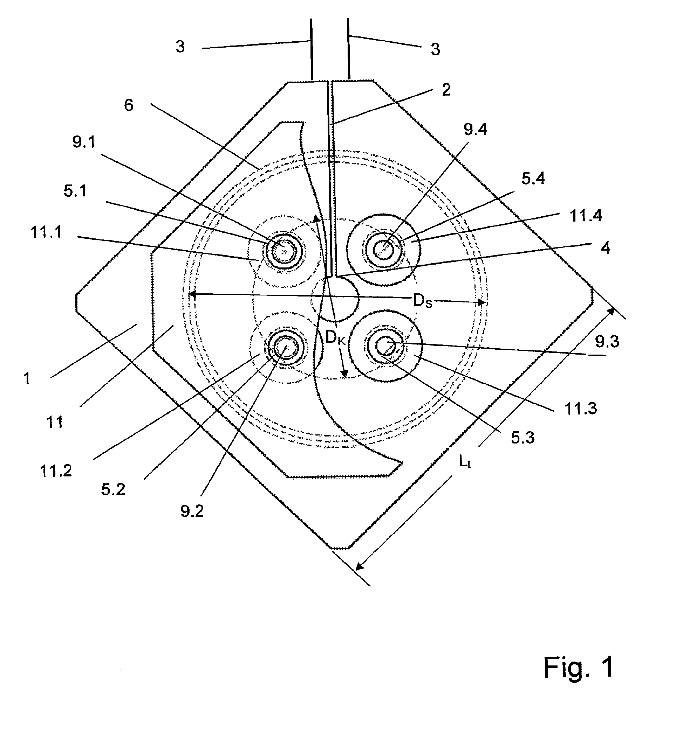

In der Fig. 1 ist eine Draufsicht auf eine erfindungsgemäß ausgeführte Induktionsspule 1 dargestellt. Die Induktionsspule 1 besteht aus einer flachen quadratischen Metallscheibe. Die Kantenlänge L_{I} der Induktionsspule 1 beträgt im Beispiel 160 mm und ihre Dicke beträgt 10 mm. Die Induktionsspule **1** weist in ihrer einer Diagonalen einen Hauptschlitz **2** auf, der in einer in der Mitte der Induktionsspule **1** befindlichen Zentralöffnung **4** mündet. Seitlich des Hauptschlitzes **2** sind jeweils die Stromzuführungen 3 für den HF-Strom angeordnet. Soweit entspricht die Ausgestaltung der Induktionsspule dem bekannten Stand der Technik. Erfindungsgemäß weist die Induktionsspule **1** zusätzlich zur Zentralöffnung **4** weitere Durchgangslöcher auf, die als Ziehöffnungen **5.1, 5.2, 5.3, 5.4** dienen. Durch diese vier Ziehöffnungen **5.1, 5.2, 5.3, 5.4** können im gewählten Beispiel vier Siliziumdünnstäbe **9.1, 9.2, 9.3, 9.4** separat oder gleichzeitig gezogen werden. Die Ziehöffnungen **5.1, 5.2, 5.3, 5.4** sind derart über die Oberfläche der Induktionsspule **1** verteilt, dass sie einen ausreichenden Seitenabstand zum Rand der Induktionsspule aufweisen. Im Beispiel sind die Ziehöffnungen **5.1, 5.2, 5.3, 5.4** konzentrisch um die Zentralöffnung **4** auf einem Kreisring angeordnet sind der einen Durchmesser **D**_{K} aufweist, der ca. die Hälfte des Durchmessers **D**_{S} des Si-Rohstabes **6** hat. Somit befinden sich die Ziehöffnungen **5.1, 5.2, 5.3, 5.4** über dem im Si-Rohstab 6 erzeugten Schmelzensee 6.1 befinden. Die Ziehöffnungen **5.1, 5.2, 5.3, 5.4** sind auf dem Kreisring in gleichmäßigen Abständen zueinander angeordnet, so dass sich die wachsenden Siliziumdünnstäbe **9.1, 9.2, 9.3, 9.4** gegenseitig thermisch nicht zu stark beeinflussen. Der Durchmesser der Ziehöffnungen **5.1, 5.2, 5.3, 5.4** ist ca. 8 mm größer als der Durchmesser der wachsenden Siliziumdünnstäbe **9.1, 9.2, 9.3, 9.4,** die hier einen Durchmesser von 8 mm aufweisen. In Abhängigkeit von der Fläche der Induktionsspule 1, die hier 160 mm x 160 mm beträgt, können so viele Ziehöffnungen in die Induktionsspule eingebracht werden, wie es die zuvor genannten Kriterien zulassen.

Unterhalb der Induktionsspule **1** befindet sich der Si-Rohstab **6** als Vorratsstab zur Bereitstellung des geschmolzenen Materials, das zum Ziehen der Siliziumdünnstäbe dient. Die Kantenlänge **D**_{I} der Induktionsspule **1** ist mit 160 mm größer als der Durchmesser **D**_{S} des Si-Rohstabes **6** mit 120 mm, so dass die Fläche der Induktionsspule **1** den gesamten Querschnitt des Si-Rohstabes überdeckt. Somit ist gewährleistet, dass das von der Induktionsspule **1** erzeugte Temperaturprofil die Kuppe des Si-Rohstabes **6** vollständig aufschmelzen kann.

Es hat sich gezeigt, dass es von Vorteil ist, wenn die im Siemens-Prozess verwendeten Siliziumdünnstäbe derart dotiert sind, dass sie eine elektrische Leitfähigkeit im Bereich von 0,05 bis 1 Ohm/cm aufweisen. Mit dieser elektrischen Leitfähigkeit lassen sich die Siliziumdünnstäbe ausschließlich elektrisch auf die notwendige Abscheidetemperatur aufheizen. Somit sind zusätzliche Heizquellen beim Prozessstart des Siemens-Prozesses nicht erforderlich. Der hier verwendete Si-Rohstab **6** weist ebenfalls eine derartige Dotierung auf.

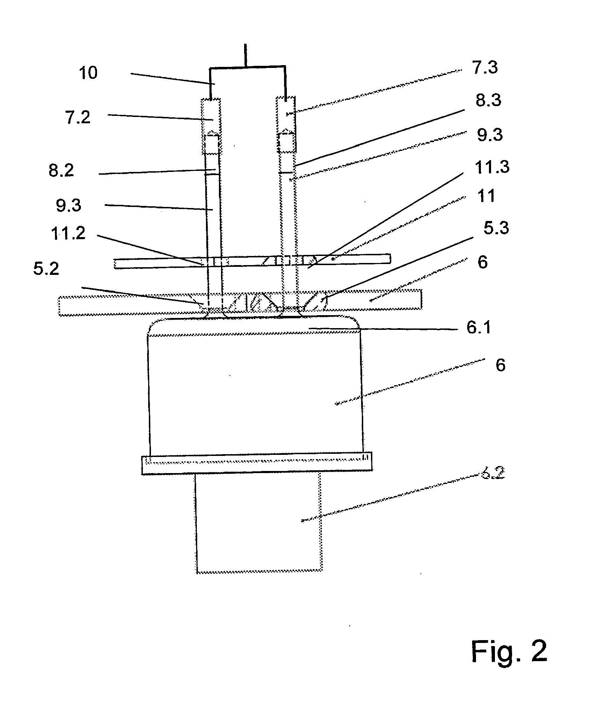

Die Fig. 2 zeigt eine schematische Seitenansicht der erfindungsgemäßen Vorrichtung. Das erfindungsgemäße Verfahren wird anhand der Fig. 2 näher erläutert. Die Ziehkammer, in der die Vorrichtung angeordnet ist und in der das Verfahren durchgeführt wird, ist nicht dargestellt. Ebenfalls nicht dargestellt sind die in der oberen Wandung der Ziehkammer angeordneten Gasschleusen.

Unter der Induktionsspule 1 befindet sich der Si-Rohstab **6,** der als Vorratsstab für die Bereitstellung des zum Ziehen der Siliziumdünnstäbe **9.1, 9.2, 9.3, 9.4** erforderlichen Materials dient, das durch das von der Induktionsspule **1** erzeugte Temperaturprofil in Form eines Schmelzensees **6.1** an der Kuppe des Si-Rohstabes **6** aufgeschmolzen wird. Der Si-Rohstab **6** ist auf einer vertikal verschiebbaren und drehbaren Spindel **6.2** angeordnet, die mit einem nicht dargestellten Motor verbunden ist.

Unmittelbar oberhalb der Induktionsspule **1,** in einem Abstand von ca. 15 mm, ist eine gekühlte Abschirmplatte **11** angeordnet, die eine induktive Wärmezufuhr von der Induktionsspule **1** zu den kristallisierenden Siliziumdünnstäben **9.1, 9.2, 9.3, 9.4** unterdrückt, wodurch ein gleichmäßiges und gerades Wachstum der Siliziumdünnstäbe ermöglicht wird. Die Abschirmplatte **11** besteht aus einer Metallplatte und weist, wie die Induktionsspule 1, einen quadratischen Querschnitt auf, dessen Kantenlänge in etwa der Kantenlänge **L**_{I} der Induktionsspule entspricht. In der Abschirmplatte **11** sind kongruent zu den Ziehöffnungen in der Induktionsspule **5.1, 5.2, 5.3, 5.4** Öffnungen **11.1, 11.2, 11.3, 11.4** in Form von Durchgangsbohrungen angeordnet. Somit können die wachsenden Siliziumdünnstäbe **9.1, 9.2, 9.3, 9.4** durch die Induktionsspule **1** und die Abschirmplatte **11** hindurch nach oben gezogen werden.

Das Verfahren beginnt damit, dass der Si-Rohstab **6** mit seiner vertikal verschiebbaren Spindel **6.2** vertikal so nahe an die vom Hochfrequenzstrom durchflossene Induktionsspule 1 herangefahren wird, dass durch das von deren Magnetfeld erzeugte Temperaturprofil unter der Induktionsspule **1** an der Kuppe des Si-Rohstabes **6** ein runder Schmelzensees **6.1** aufgeschmolzen wird.

Im nächsten Schritt werden die an den Trägern **7.1, 7.2, 7.3, 7.4** befestigten Silizium-Keimstäbchen **8.1, 8.2, 8.3, 8.4** mittels einer Ziehvorrichtung **10** durch die Öffnungen **11.1, 11.2, 11.3, 11.4** in der Abschirmplatte **11** und die Ziehöffnungen **5.1, 5.2, 5.3, 5.4** in der Induktionsspule **1** hindurch soweit vertikal abgesenkt, bis sie den Schmelzensee **6.1** berühren. Mit Beginn des Kristallwachstums werden die Träger **7.1, 7.2, 7.3, 7.4** mit einer Geschwindigkeit von ca. 10mm/min. nach oben gezogen, so dass an jedem Silizium-Keimstäbchen **8.1, 8.2, 8.3, 8.4,** die jeweils an einem Träger **7.1, 7.2, 7.3, 7.4** befestigt sind, ein Siliziumdünnstab **9.1, 9.2, 9.3, 9.4** wächst. Im gewählten Beispiel sind die Träger **7.1, 7.2, 7.3, 7.4** miteinander und einer gemeinsamen Ziehvorrichtung **10** verbunden, so dass alle Träger synchron, gleichzeitig und mit gleicher Ziehgeschwindigkeit nach oben bewegt werden, so dass für jeden Siliziumdünnstab **9.1, 9.2, 9.3, 9.4** ein gleiches Kristallwachstum gewährleistet ist.

Die an den jeweiligen Silizium-Keimstäbchen **8.1, 8.2, 8.3, 8.4** wachsenden Siliziumdünnstäbe **9.1, 9.2, 9.3, 9.4** werden über die jeweiligen Träger **7.1, 7.2, 7.3, 7.4** durch die jeweiligen Ziehöffnungen **5.1, 5.2, 5.3, 5.4** in der Induktionsspule **1** sowie die Öffnungen **11.1, 11.2, 11.3, 11.4** in der Abschirmplatte **11** kontinuierlich nach oben gezogen bis der aufgeschmolzene Materialvorrat des Si-Rohstabes **6** verbraucht ist.

Während die wachsenden Siliziumdünnstäbe **9.1, 9.2, 9.3, 9.4** mittels der Träger **7.1, 7.2, 7.3, 7.4** nach oben gezogen werden, wird Si-Rohstab **6** mit seiner verschiebbaren Spindel **6.2** vertikal nach oben nachgeführt, so dass stets ein ausreichender aufgeschmolzener Materialvorrat im Schmelzensee **6.1** unter der Induktionsspule **1** für das Kristallwachstum der Siliziumdünnstäbe **9.1, 9.2, 9.3, 9.4** zur Verfügung steht. Vorteilhafterweise wird der Si-Rohstab 6 mit der Spindel **6.2** gedreht, so dass unter der Induktionsspule 1 ein gleichmäßig aufgeschmolzener Schmelzensee 6.1 erzeugt wird.

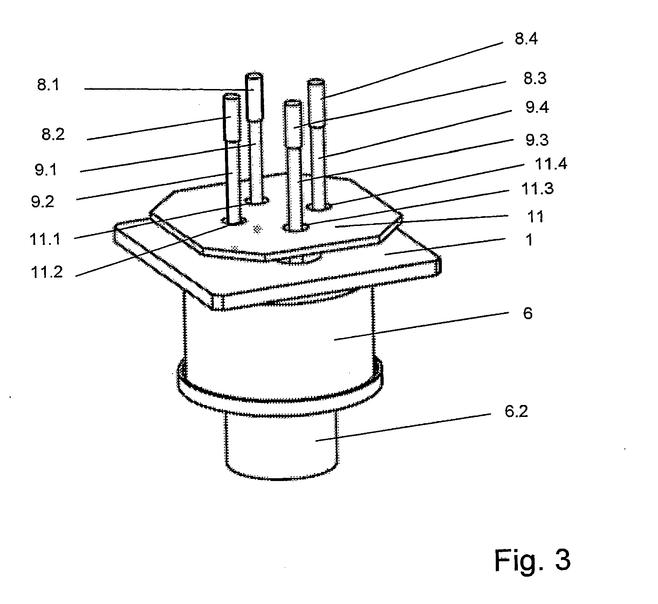

Die Fig. 3 zeigt eine perspektivische Darstellung der erfindungsgemäßen Vorrichtung. Deutlich ist zu sehen, wie vier Siliziumdünnstäbe **9.1, 9.2, 9.3, 9.4** gleichzeitig gezogen werden. Der Si-Rohstab **6** ist zu erkennen, der auf der Spindel **6.2** angeordnet ist und von der Induktionsspule **1** sowie auch von der Abschirmplatte **11** überragt wird. Durch die Öffnungen **11.1, 11.2, 11.3, 11.4** in der Abschirmplatte **11** ragen vier wachsende Siliziumdünnstäbe **9.1, 9.2, 9.3, 9.4** heraus, an deren oberen Enden die vier Silizium-Keimstäbchen **8.1, 8.2, 8.3, 8.4** zu sehen sind. Die Träger **7.1, 7.2, 7.3, 7.4** sowie die gemeinsame Ziehvorrichtung **10** sind hier nicht dargestellt.

### Aufstellung der verwendeten Bezugszeichen

- 1: Induktionsspule
- 2: Hauptschlitz
- 3: Stromzuführungen
- 4: Zentralöffnung
- 5.1, 5.2, 5.3, 5.4: Ziehöffnungen
- 6: Si-Rohstab
- 6.1: Schmelzensee
- 6.2: Spindel
- 7.1, 7.2, 7.3, 7.4: Träger
- 8.1, 8.2, 8.3, 8.4: Silizium-Keimstäbchen
- 9.1, 9.2, 9.3, 9.4: Siliziumdünnstäbe
- 10: Ziehvorrichtung
- 11: Abschirmplatte
- 11.1, 11.2, 11.3, 11.4: Öffnungen in der Abschirmung
- L_{I}: Kantenlänge der Induktionsspule
- D_{S}: Durchmesser des Si-Rohstabes
- D_{K}: Durchmesser des Kreises auf dem die Ziehöffnungen angeordnet sind

## Patentansprüche

1. Verfahren zur Herstellung von Siliziumdünnstäben nach einem tiegelfreien Kristallisationsverfahren, bei dem aus der Schmelze am oberen Ende eines Si-Rohstabs, der einen technisch üblichen Durchmesser aufweist, die durch die flache vom HF-Strom durchflossene Induktionsspule, die nur eine Windung aufweist und aus einer Scheibe mit einem Schlitz als Stromzuführung besteht, erzeugt wird, Siliziumdünnstäbe durch die flache Induktionsspule hindurch nach oben gezogen werden,
**dadurch gekennzeichnet, dass**
die flache Induktionsspule (1), die nur der induktiven Heizung der Schmelze dient, neben der stromumflossenen Zentralöffnung (4), durch die kein Siliziumdünnstab gezogen wird, weitere Ziehöffnungen (5.1, 5.2, 5.3, 5.4) aufweist, durch die jeweils ein Siliziumdünnstab (9.1, 9.2, 9.3, 9.4) gezogen wird.

2. Verfahren nach Anspruch 1,
**dadurch gekennzeichnet, dass**
in der Startphase mehrere Silizium-Keimstäbchen (8.1, 8.2, 8.3, 8.4), die jeweils an einem Träger (7.1, 7.2, 7.3, 7.4) befestigt sind, in den von der Induktionsspule (1) aufgeschmolzenen Schmelzensee (6.1) an der Kuppe des Si-Rohstabes (6) durch die Ziehöffnungen (5.1, 5.2, 5.3, 5.4) hindurch die Schmelze berühren und dann die Züchtung erfolgt, indem die Silizium-Keimstäbchen (8.1, 8.2, 8.3, 8.4) jeweils durch eine Ziehöffnung (5.1, 5.2, 5.3, 5.4) nach oben gezogen werden.

3. Verfahren nach Anspruch 1,
**dadurch gekennzeichnet, dass**
oberhalb der Induktionsspule (1) Mittel vorgesehen sind, die eine induktive Wärmezufuhr zu den kristallisierenden Siliziumdünnstäben (9.1, 9.2, 9.3, 9.4) unterdrücken.

4. Verfahren nach Anspruch 1,
**dadurch gekennzeichnet, dass**
die Träger (7.1, 7.2, 7.3, 7.4) mit den Silizium-Keimstäbchen (8.1, 8.2, 8.3, 8.4). und den daran wachsenden Siliziumdünnstäben (9.1, 9.2, 9.3, 9.4) synchron nach oben gezogen werden.

5. Verfahren nach Anspruch 1,
**dadurch gekennzeichnet, dass**
der Si-Rohstab (6) während des Ziehprozesses mit einer solchen Geschwindigkeit nach oben nachgeführt wird, dass im Schmelzensee (6.1) stets eine ausreichende geschmolzene Materialmenge für die Züchtung der Siliziumdünnstäbe (9.1, 9.2, 9.3, 9.4) zur Verfügung steht.

6. Verfahren nach Anspruch 1,
**dadurch gekennzeichnet, dass**
der verwendete Si-Rohstab (6) eine solche Dotierung mit Bor und/oder anderen dotierenden Stoffen aufweist, dass die gezogenen Siliziumdünnstäbe (9.1, 9.2, 9.3, 9.4) die gewünschte Dotierung aufweisen.

7. Verfahren nach Anspruch 1,
**dadurch gekennzeichnet, dass**
dass der Dotierstoff der Schmelze im Prozess zugeführt wird.

8. Verfahren nach Anspruch 1,
**dadurch gekennzeichnet, dass**
das Verfahren in einem geschlossenen Gefäß unter Schutzgasatmosphäre ausgeführt wird.

9. Verfahren nach Anspruch 7,
**dadurch gekennzeichnet, dass**
die wachsenden Siliziumdünnstäbe (9.1, 9.2, 9.3, 9.4) durch Gasschleusen, die sich im oberen Teil der Ziehkammer befinden, kontinuierlich aus der Ziehkammer heraus bis in den Außenraum gezogen werden, so dass der Ziehprozess andauern kann bis der aufgeschmolzene Materialvorrat des Si-Rohstabes (6) verbraucht ist.

10. Vorrichtung zur Durchführung des Verfahrens nach den Ansprüchen 1 bis 8, wobei eine flache Induktionsspule, die nur eine Windung aufweist und aus einer Scheibe mit einem Schlitz als Stromzuführung besteht, verwendet wird,
**dadurch gekennzeichnet, dass**
die Induktionsspule (1) neben der vom HF-Strom umflossenen Zentralöffnung (4) weitere Ziehöffnungen (5.1, 5.2, 5.3, 5.4) aufweist, die nicht von einem Ringstrom umflossen werden und durch die jeweils ein Siliziumdünnstab (9.1, 9.2, 9.3, 9.4) ziehbar ist.

11. Vorrichtung nach Anspruch 10,
**dadurch gekennzeichnet, dass**
die weiteren Ziehöffnungen (5.1, 5.2, 5.3, 5.4) konzentrisch zur Zentralöffnung (4) und mit nahezu gleichem Abstand zueinander angeordnet sind.

12. Vorrichtung nach Anspruch 10,
**dadurch gekennzeichnet, dass**
die weiteren Ziehöffnungen (5.1, 5.2, 5.3, 5.4) paarweise und jeweils symmetrisch zur Zentralöffnung (4) angeordnet sind.

13. Vorrichtung nach Anspruch 10,
**dadurch gekennzeichnet, dass**
der Querschnitt der einwindigen Induktionsspule (1) vollständig den Querschnitt des Si-Rohstabes (6) überdeckt.

14. Vorrichtung nach Anspruch 10,
**dadurch gekennzeichnet, dass**
in einem geringen Abstand oberhalb der Induktionsspule (1) eine Abschirmplatte (11) angeordnet ist, die kongruent zu den Ziehöffnungen (5.1, 5.2, 5.3, 5.4) in der Induktionsspule (1) angeordnete Öffnungen (11.1, 11.2, 11.3, 11.4) aufweist.

15. Vorrichtung nach Anspruch 10,
**dadurch gekennzeichnet, dass**
der Si-Rohstab (6) auf einer vertikal verschiebbaren und drehbaren Spindel (6.2) angeordnet ist.

16. Vorrichtung nach Anspruch 10,
**dadurch gekennzeichnet, dass**
jedes Silizium-Keimstäbchen (8.1, 8.2, 8.3, 8.4) an dem ein Siliziumdünnstab (9.1, 9.2, 9.3, 9.4) ziehbar ist, mit einem vertikal verschiebbaren Träger (7.1, 7.2, 7.3, 7.4) verbunden ist.

17. Vorrichtung nach Anspruch 10,
**dadurch gekennzeichnet, dass**
alle Träger (7.1, 7.2, 7.3, 7.4) synchron, gleichzeitig und mit gleicher Geschwindigkeit nach oben bewegbar sind.

18. Vorrichtung nach Anspruch 10 und 16,
**dadurch gekennzeichnet, dass**
alle Träger (7.1, 7.2, 7.3, 7.4) an einer gemeinsamen Ziehvorrichtung (10) angeordnet sind.

19. Vorrichtung nach Anspruch 10,
**dadurch gekennzeichnet, dass**
die Vorrichtung in einer gasdichten Ziehkammer angeordnet ist, welche in ihrer oberen Gefäßwand, über den Ziehöffnungen (5.1, 5.2, 5.3, 5.4) in der Induktionsspule (1) und den Öffnungen (11.1, 11.2, 11.3, 11.4) in der Abschirmplatte (11), Gasschleusen in Form von langen Röhren aufweist, durch die die Siliziumdünnstäbe (9.1, 9.2, 9.3, 9.4) ziehbar sind.

## Claims

1. A method for producing silicon thin rods by a floating zone crystallisation process, in which silicon thin rods are drawn upwardly through the flat induction coil from the melt at the upper end of a raw silicon rod, which has a technically conventional diameter and is produced by the flat induction coil through which HF current is passed and which has only one turn and consists of a disc having a slit as a current feed,
**characterised in that**
the flat induction coil (1), which serves only to inductively heat the melt, besides the central opening (4), around which current is passed and through which no silicon thin rod is drawn, also comprises further drawing openings (5.1, 5.2, 5.3, 5.4), through each of which a silicon thin rod (9.1, 9.2, 9.3, 9.4) is drawn.

2. The method according to Claim 1,
**characterised in that**,
in the start phase, a plurality of silicon seed rods (8.1, 8.2, 8.3, 8.4), which are each fastened to a support (7.1, 7.2, 7.3, 7.4), contact the melt in the melt pool (6.1) melted by the induction coil (1) at the crest of the raw silicon rod (6) through the drawing openings (5.1, 5.2, 5.3, 5.4), and growth then occurs by drawing each of the silicon seed rods (8.1, 8.2, 8.3, 8.4) upwardly through a drawing opening (5.1, 5.2, 5.3, 5.4).

3. The method according to Claim 1,
**characterised in that**
means are provided above the induction coil (1) which suppress an inductive heat feed to the crystallising silicon thin rods (9.1, 9.2, 9.3, 9.4).

4. The method according to Claim 1,
**characterised in that**
the supports (7.1, 7.2, 7.3, 7.4) with the silicon seed rods (8.1, 8.2, 8.3, 8.4) and the silicon thin rods (9.1, 9.2, 9.3, 9.4) growing thereon are drawn upwardly synchronously.

5. The method according to Claim 1,
**characterised in that**
the raw silicon rod (6) is drawn upwardly during the drawing process at such a speed that a sufficiently melted quantity of material is always present in the melt pool (6.1) for the growth of the silicon thin rods (9.1, 9.2, 9.3, 9.4).

6. The method according to Claim 1,
**characterised in that**
the used raw silicon rod (6) has such a doping with boron and/or other doping substances that the drawn silicon thin rods (9.1, 9.2, 9.3, 9.4) have the desired doping.

7. The method according to Claim 1,
**characterised in that**
the dopant is fed to the melt in the process.

8. The method according to Claim 1,
**characterised in that**
the method is carried out in a closed vessel under an inert gas atmosphere.

9. The method according to Claim 7,
**characterised in that**
the growing silicon thin rods (9.1, 9.2, 9.3, 9.4) are drawn continuously from the drawing chamber into the outer area by means of gas locks located in the upper part of the drawing chamber, such that the drawing process can last until the molten material stock of the raw silicon rod (6) is depleted.

10. A device for carrying out the method according to Claims 1 to 8, wherein a flat induction coil is used which has only one turn and consists of a disc having a slit as a current feed,
**characterised in that**
the induction coil (1), besides the central opening (4) around which HF current is passed, also has further drawing openings (5.1, 5.2, 5.3, 5.4), through which a ring current is not passed and through each of which a silicon thin rod (9.1, 9.2, 9.3, 9.4) can be drawn.

11. The device according to Claim 10,
**characterised in that**
the further drawing openings (5.1, 5.2, 5.3, 5.4) are arranged concentrically with the central opening (4) and at practically the same distance from one another.

12. The device according to Claim 10,
**characterised in that**
the further drawing openings (5.1, 5.2, 5.3, 5.4) are arranged in pairs and in each case symmetrically with respect to the central opening (4).

13. The device according to Claim 10,
**characterised in that**
the cross section of the single-turn induction coil (1) completely covers the cross section of the raw silicon rod (6).

14. The device according to Claim 10,
**characterised in that**
a shielding plate (11) is arranged at a short distance above the induction coil (1) and has openings (11.1, 11.2, 11.3, 11.4) arranged congruently with respect to the drawing openings (5.1, 5.2, 5.3, 5.4) in the induction coil (1).

15. The device according to Claim 10,
**characterised in that**
the raw silicon rod (6) is arranged on a vertically displaceable and rotatable spindle (6.2).

16. The device according to Claim 10,
**characterised in that**
each silicon seed rod (8.1, 8.2, 8.3, 8.4), on which a silicon thin rod (9.1, 9.2, 9.3, 9.4) can be drawn, is connected to a vertically displaceable support (7.1, 7.2, 7.3, 7.4).

17. The device according to Claim 10,
**characterised in that**
all supports (7.1, 7.2, 7.3, 7.4) can be moved upwardly synchronously, simultaneously and at the same speed.

18. The device according to Claim 10 and 16,
**characterised in that**
all supports (7.1, 7.2, 7.3, 7.4) are arranged on a common drawing device (10).

19. The device according to Claim 10,
**characterised in that**
the device is arranged in a gas-tight drawing chamber, which, in its upper vessel wall, above the drawing openings (5.1, 5.2, 5.3, 5.4) in the induction coil (1) and the openings (11.1, 11.2, 11.3, 11.4) in the shielding plate (11), has gas locks in the form of long tubes, through which the silicon thin rods (9.1, 9.2, 9.3, 9.4) can be drawn.

## Revendications

1. Procédé de fabrication de fines barres de silicium selon un procédé de cristallisation sans creuset, lors duquel à partir de la masse fondue, sur l'extrémité supérieure d'une barre brute en Si qui présente un diamètre usuel du point de vue technique, on créé la bobine d'induction HF plate, traversée par le courant HF qui ne comporte qu'une seule spire et qui est constituée d'un disque avec une encoche en tant qu'alimentation en courant électrique, on tire des fines barres de silicium vers le haut, à travers la bobine d'injection plate ,
**caractérisé en ce que**
à côté de l'orifice central (4) autour duquel circule du courant et à travers lequel on ne tire aucune fine barre de silicium, la bobine d'induction (1) plate, qui sert exclusivement au chauffage par induction de la masse fondue, comporte des orifices d'étirage (5.1, 5.2, 5.3, 5.4) supplémentaires, à travers chacun desquels on tire une fine barre de silicium (9.1, 9.2, 9.3, 9.4).

2. Procédé selon la revendication 1
**caractérisé en ce que**
dans la phase de démarrage, dans le lac de masse en fusion (6.1) fondue par la bobine d'induction (1), sur la calotte de la barre brute en Si (6), plusieurs tiges de germe de silicium (8.1, 8.2, 8.3, 8.4), dont chacune est fixée sur un support (7.1, 7.2, 7.3, 7.4), à travers les orifices de tirage (5.1, 5.2, 5.3, 5.4) sont en contact avec la masse en fusion et **en ce qu'**on procède ensuite à la culture, en tirant vers le haut les tiges de germe de silicium (8.1, 8.2, 8.3, 8.4), chaque fois à travers un orifice de tirage (5.1, 5.2, 5.3, 5.4).

3. Procédé selon la revendication 1,
**caractérisé en ce**
**qu'**au-dessus de la bobine d'induction (1) sont prévus des moyens qui suppriment un apport de chaleur par induction vers les fines barres de silicium (9.1, 9.2, 9.3, 9.4) en cristallisation.

4. Procédé selon la revendication 1
**caractérisé en ce**
**qu'**on tire vers le haut, de manière synchronisée les supports (7.1, 7.2, 7.3, 7.4) avec les tiges de germe de silicium (8.1, 8.2, 8.3, 8.4) et les fines barres de silicium (9.1, 9.2, 9.3, 9.4) qui y poussent.

5. Procédé selon la revendication 1
**caractérisé en ce que**
pendant le processus de tirage, on fait suivre la barre brute de Si (6) vers le haut à une vitesse telle que dans le lac de masse en fusion (6.1), une masse de matière fondue suffisante pour la culture des fines barres en silicium (9.1, 9.2, 9.3, 9.4) soit toujours disponible.

6. Procédé selon la revendication 1
**caractérisé en ce que**
la barre brute en Si (6) utilisée présente un dopage en bore et/ou en d'autres matières dopantes tel, que les fines barres de silicium (9.1, 9.2, 9.3, 9.4) tirées présentent le dopage souhaité.

7. Procédé selon la revendication 1
**caractérisé en ce**
**qu'**on amène la matière de dopage vers la masse en fusion pendant le processus.

8. Procédé selon la revendication 1
**caractérisé en ce que**
le procédé est réalisé dans un contenant fermé, sous atmosphère de gaz protecteur.

9. Procédé selon la revendication 7
**caractérisé en ce**
**qu'**on tire les fines tiges de silicium (9.1, 9.2, 9.3, 9.4) en croissance à travers des écluses à gaz qui se trouvent dans la partie supérieure de la chambre d'étirage en continu hors de la chambre d'étirage jusque vers l'extérieur, de telle sorte que le processus d'étirage puisse durer jusqu'à ce la réserve de matière en fusion de la barre brute en Si (6) soit consommée.

10. Dispositif pour la réalisation du procédé selon les revendications 1 à 8, sachant qu'on utilise une bobine d'induction plate, ne comportant qu'une seule spire et constituée d'un disque avec une encoche en tant qu'alimentation en courant électrique,
**caractérisé en ce**
**qu'**à côté de l'orifice central (4) autour duquel circule du courant, la bobine d'induction (1) comporte des orifices d'étirage (5.1, 5.2, 5.3, 5.4) supplémentaires, autour desquels ne circule pas un courant annulaire et à travers chacun desquels on peut tirer une fine barre de silicium (9.1, 9.2, 9.3, 9.4).

11. Dispositif selon la revendication 10
**caractérisé en ce que**
les orifices d'étirage (5.1, 5.2, 5.3, 5.4) supplémentaires sont placés de manière concentrique par rapport à l'orifice central (4) et avec un écart pratiquement égal entre eux.

12. Dispositif selon la revendication 10
**caractérisé en ce que** les orifices d'étirage (5.1, 5.2, 5.3, 5.4) supplémentaires sont placés par paires et chaque fois en symétrie de l'orifice central (4).

13. Dispositif selon la revendication 10
**caractérisé en ce que**
la section transversale de la bobine d'induction (1) à une seule spire recouvre totalement la section transversale de la barre brute en Si (6).

14. Dispositif selon la revendication 10
**caractérisé en ce**
**qu'**avec un faible écart est placée au-dessus de la bobine d'induction (1) une plaque de protection (11) qui comporte des orifices (11.1, 11.2, 11.3, 11.4 placés de manière congruente par rapport aux orifices d'étirage (5.1, 5.2, 5.3, 5.4) dans la bobine d'induction (1).

15. Dispositif selon la revendication 10
**caractérisé en ce que**
la barre brute en Si (6) est placée sur une broche (6.2) déplaçable à la verticale et rotative.

16. Dispositif selon la revendication 10
**caractérisé en ce que**
chaque tige de germe de silicium (8.1, 8.2, 8.3, 8.4) sur laquelle on peut étirer une fine barre de silicium (9.1, 9.2, 9.3, 9.4) est reliée avec un support (7.1, 7.2, 7.3, 7.4) déplaçable à la verticale.

17. Dispositif selon la revendication 10
**caractérisé en ce que** tous les supports (7.1, 7.2, 7.3, 7.4) sont déplaçables vers le haute de manière synchrone, simultanément et à la même vitesse.

18. Dispositif selon la revendication 10 et la revendication 16,
**caractérisé en ce que**
tous les supports (7.1, 7.2, 7.3, 7.4) sont placés sur un dispositif d'étirage (10) commun.

19. Dispositif selon la revendication 10
**caractérisé en ce que**
le dispositif est placé dans une chambre d'étirage étanche au gaz, laquelle comporte dans sa paroi supérieure de contenant au-dessus des orifices d'étirage (5.1, 5.2, 5.3, 5.4) dans la bobine d'induction (1) et des orifices (11.1, 11.2, 11.3, 11.4) dans la plaque de protection (11) des écluses à gaz sous la forme de longs tubes, à travers lesquels on peut tirer les fines barres de silicium (9.1, 9.2, 9.3, 9.4).
